Europäisches Patentamt

European Patent Office

Office européen des brevets

(11) Publication number: **0 160 149 B1**

(12) **EUROPEAN PATENT SPECIFICATION**

(45) Date of publication of patent specification: **02.01.92** (51) Int. Cl.⁵: **H03C 3/08**

(21) Application number: **84308320.5**

(22) Date of filing: **30.11.84**

(54) **Pre-distortion shaping networks.**

(30) Priority: **23.04.84 US 602650**

(43) Date of publication of application:
**06.11.85 Bulletin 85/45**

(45) Publication of the grant of the patent:
**02.01.92 Bulletin 92/01**

(84) Designated Contracting States:
**DE FR GB**

(56) References cited:
**DE-A- 2 000 582      FR-A- 1 307 700**
**FR-A- 2 382 798      FR-A- 2 521 368**
**US-A- 3 684 982      US-A- 4 117 422**

(73) Proprietor: **Hewlett-Packard Company**
**Mail Stop 20 B-O, 3000 Hanover Street**
**Palo Alto, California 94304(US)**

(72) Inventor: **Miller, Brian Mark**
**South 1016 Mariam**
**Spokane Washington 99206(US)**

(74) Representative: **KOHLER SCHMID + PARTNER**
**Patentanwälte**
**Ruppmannstrasse 27**
**W-7000 Stuttgart 80(DE)**

## Description

The present invention relates to a network for reducing distortion in the modulation of the output signal of a voltage controlled oscillator in accordance with the precharacterizing part of claim 1.

Distortion in the modulation of a voltage-controlled oscillator (VCO) is a well-known problem. Frequently, a non-linear shaping function is employed to shape the modulating signal of a VCO for reducing distortion in the frequency modulation (FM) component of the output signal of the VCO.

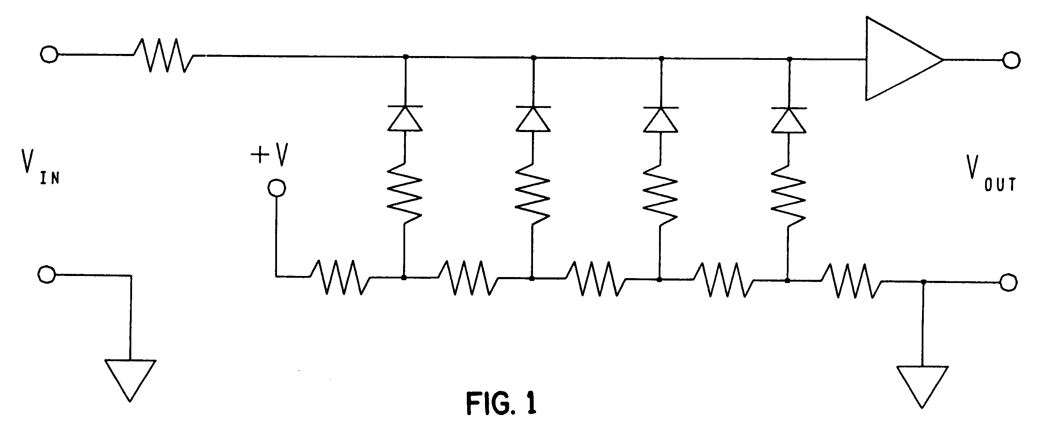

The network according to the precharacterizing part of claim 1 is shown in Fig. 1 and utilizes a diode-resistor network, the resistors of which are typically selected for reduced distortion in VCO output which is time consuming and expensive. Distortion specifications for VCO's which employ such a network, range from about -29 dB to about -54 dB.

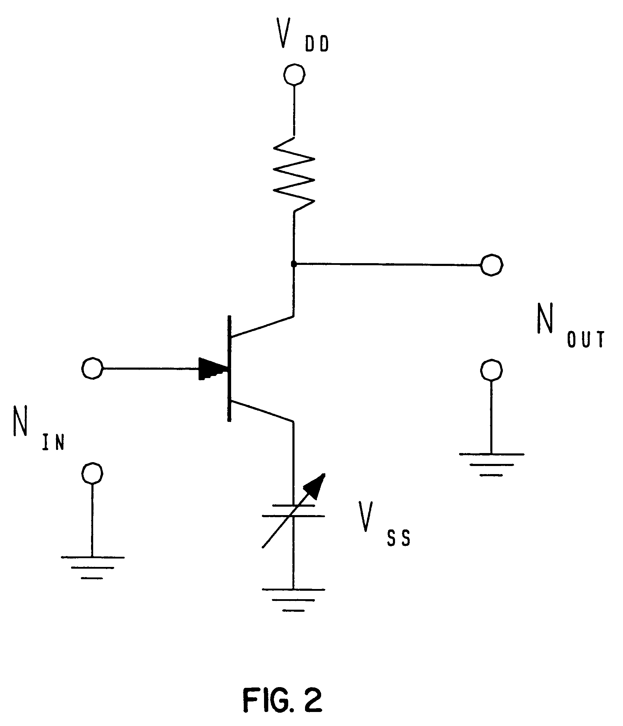

In another prior art shaping network shown in Fig. 2, the $V_{GS}$-$I_D$ characteristic of a field-effect transistor (FET) is used to pre-distort the modulating signal of a VCO to reduce distortion. Since the FET operates in the saturated region of its characteristic, the non-linearity achievable for modulation of the VCO is essentially uncontrollable because it cannot be reduced below a computable minimum. Thus, VCO output distortion is typically no better than -30 dB.

FR-A-1 307 700 (see Fig. 9) discloses a network for reducing distortion in the modulation of the output signal of a voltage controlled tank circuit, said network being arranged for shaping the modulation signal of the voltage controlled tank circuit and comprises a voltage divider which includes a semiconductor device employed as one of the resistive elements of the divider. The semiconductor device of this known circuit is a bipolar transistor having an exponential transfer characteristic similar to the charge-discharge characteristics of a typical capacitor. In fact, the transistor is used in place of a capacitor to produce a desired exponential voltage.

The object of the present invention is to provide a network for reducing distortion in the modulation of the output signal of a voltage controlled oscillator, which network can significantly reduce the FM distortion in the output signal of a voltage controlled oscillator.

The above object is solved by a network for reducing distortion in the modulation of the output signal of a voltage controlled oscillator, said network comprising a voltage divider coupled to the voltage controlled oscillator for shaping its modulating signal, the network having a characteristic transfer function.

According to the invention (Claim 1) this network is characterized in that said voltage divider includes as one of its resistive elements a field effect transistor biased for unsaturated non-linear operation for providing a controllable non-linear resistance, said field effect transistor being coupled in parallel to the input path of said network and introducing a controlled amount of second order non-linearity to said characteristic transfer function which is given by the relation:

$$V_{OUT} = \frac{R_{ON}}{R_{ON} + R} \cdot V_{IN} - \left[ \frac{R^2_{ON}\, R}{2\, |V_P|\, (R_{ON} + R)^3} \right] V^2_{IN}$$

where $R_{ON}$ is the resistance of the drain-to-sink channel of the field effect transistor evaluated when the gate-to-sink voltage is zero, R is the resistance of a resistor element of the voltage divider, said resistor element being serially coupled to the input path of said network, $V_P$ is the pinch-off voltage for the field effect transistor and $V_{IN}$ and $V_{OUT}$ are the input voltage and output voltage of said network, respectively.

The above object is also solved by a network for reducing distortion in the modulation of the output signal of a voltage controlled oscillator, said network comprising a voltage divider coupled to the voltage controlled oscillator for shaping its modulating signal, the network having a characteristic transfer function.

According to the invention (Claim 2) network is characterized in that said voltage divider includes as one of its resistive elements a field effect transistor biased for unsaturated non-linear operation for providing a controllable non-linear resistance, said field effect transistor being coupled in series to the input path of said network and introducing a controlled amount of second order non-linearity to said characteristic transfer function which is given by the relation

2

EP 0 160 149 B1

$$V_{OUT} = \frac{R}{R + R_{ON}} \cdot \left[ V_{IN} - \frac{R^2{}_{ON}}{2 \, |V_P| \, (R + R_{ON})^2} \, V^2{}_{IN} \right],$$

where $R_{ON}$ is the resistance of the drain-to-sink channel of the field effect transistor evaluated when the gate-to-sink voltage is zero, R is the resistance of a resistor of the voltage divider, said resistor being coupled in parallel to the input path of said network, $V_P$ is the pinch-off voltage for the field effect transistor and $V_{IN}$ and $V_{OUT}$ are the input voltage and output voltage of the network, respectively.

According to preferred embodiment a voltage amplifier having a predetermined gain is coupled between the voltage divider network and the voltage controlled oscillator for amplifying the shaped modulating signal.

According to further preferred embodiment a summing circuit is coupled between the voltage divider network and the voltage controlled oscillator for summing the shaped modulating signal with an oscillator tuning voltage.

A pre-distortion shaping network constructed according to the principles of the present invention provides a second order voltage transfer function, the first and second order coefficients of which may be independently selected. The non-linearity of that voltage transfer function is approximately equal to the inverse of the VCO frequency modulation transfer function non-linearity.

The shaping network of the present invention provides at least 30 dB improvement in VCO FM distortion. Typically, -90 dB distortion is obtainable.

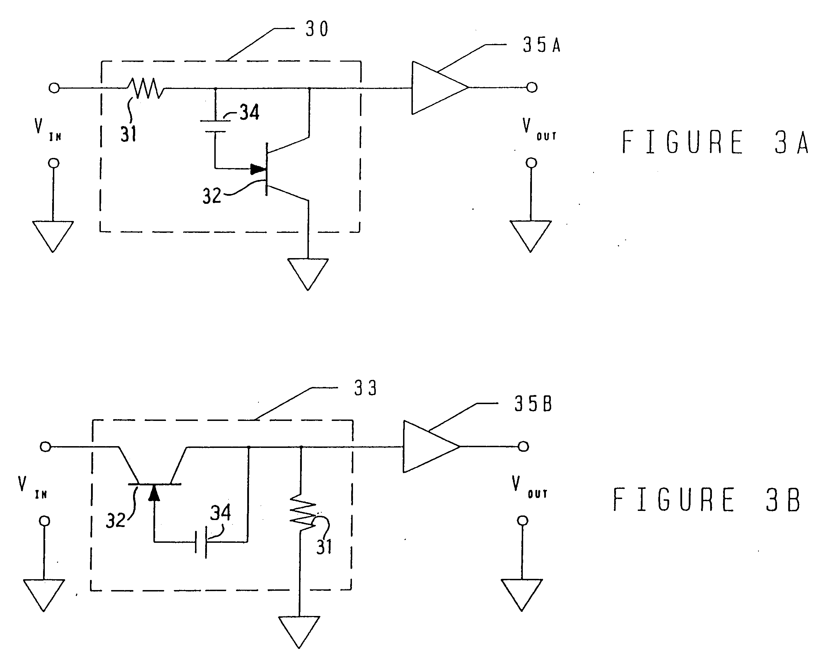

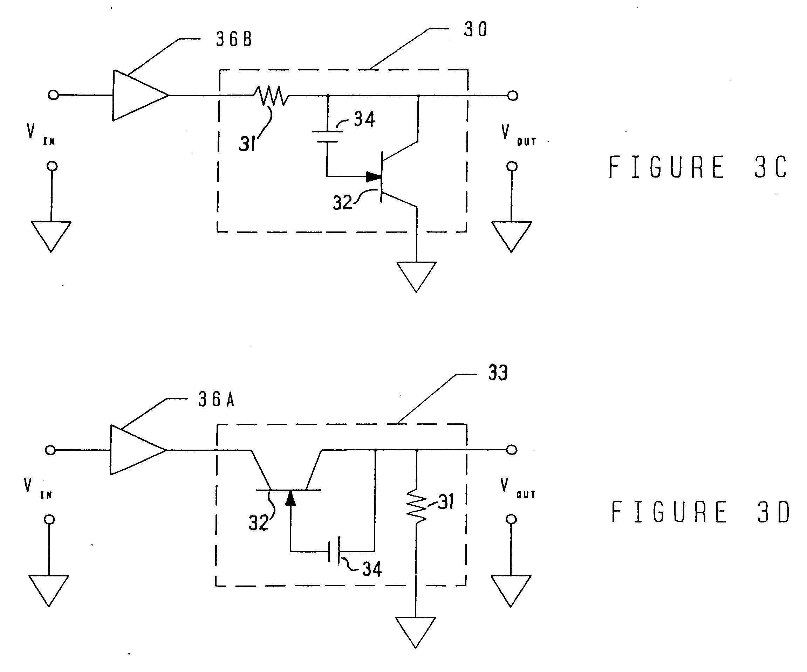

There now follows a detailed description which is to be read with reference to Figures 3 to 7 of the accompanying drawings of networks according to the invention; it is to be clearly understood that these networks have been selected for description to illustrate the invention by way of example and not by way of limitation.

In the accompanying drawings:-

Figures 3A, 3B, 3C and 3D are schematics of predistortion shaping networks constructed according to the principles of the present invention;

Figure 4 is a schematic diagram of a typical oscillator tank circuit;

Figure 5 is a block diagram including transfer function g(v);

Figure 6 is a schematic diagram of an FET biased to operate in its linear region; and

Figure 7 is a diagram of $V_{DS}$-$I_D$ characteristic curve of an FET for operation in the unsaturated region.

An analysis of the non-linear shaping function required by a typical VCO to produce substantially distortion-free FM output signals, shows that the predistortion shaping required is predominantly second order and is given by the following relation:

## EQUATION A

$$g(v) = V - \left[ \frac{1 + \sigma}{2} - \frac{3\sigma}{4\left(1 + \frac{C_p}{C_{AV}}\right)} \right] \cdot \frac{v^2}{\phi + V_o}$$

The derivation of equation A is given in Appendix A to this specification. The analysis is not necessary to understand the operation of the FET shaping network of the present invention, but is required to design such a shaping network for a particular VCO.

The transfer function of the FET shaping network of the present invention is given by the relation:

## EQUATION B

$$V_{OUT} = \frac{R_{ON}}{R_{ON} + R} \cdot \left[ V_{IN} - \frac{R^2_{ON}}{2 (R_{ON} + R)^3} \frac{R}{|V_P|} V^2_{IN} \right]$$

Where $R_{ON}$ is the resistance of the drain to sink junction of semiconductor device 32 evaluated when the gate-to-sink voltage is zero; i.e., $V_{GS} = 0$ (see Exhibit B, page 16);

where R is the resistance of resistor 31 (as shown in Figs. 3A-3D);

where $V_P$ is the pinch-off voltage for semiconductor device 32 (as shown in Figs 3A-3D); and

where $V_{in}$ and $V_{out}$ are the input voltage and output voltage, respectively, of the shaping network 30 and 33 (as shown in Figs. 3A-3D).

The derivation of equation B is given in Appendix B to this specification.

The transfer function of the FET shaping network 33 (as shown in Figs. 3B and 3D) of the present invention is given by the relation:

## Equation C

$$V_{out} = \frac{R}{R + R_{ON}} \cdot \left[ V_{in} - \frac{R^2_{ON}}{2 |V_P| (R + R_{ON})^2} V^2_{in} \right]$$

The derivation of equation C is given in Appendix C to this specification.

The close match between equations A and B and equations A and C indicate that a shaping network according to the present invention very closely approximates the shaping required to linearize the output FM modulation of the VCO signal.

A comparison of equations A and B also shows the improvement of the present invention over traditional prior art diode-resistor shaping network. Such networks provide a transfer function comprised of interconnected straight-line segments having brake points at the interconnection which approximate the desired curve. The more break points, the better the approximation, and many such break points are required to suppress higher order terms of the transfer function which are also produced by the network. The FET shaping network provides a transfer function having no break points and is inherently low in higher order terms.

The shaping networks 30,33 of Fig. 3A-3D are resistive voltage dividers in which a semiconductor device 32, namely an FET, is employed as one of the two resistances in the divider. Two basic configurations of the divider are provided; the dividers 30 in Fig. 3A and 3C are the same as each other but different from the dividers 33 in Fig. 3B and 3D. Such networks are utilized to shape the modulating signal of a VCO to reduce distortion in the FM component of the output signal of a VCO.

A shaping network according to the present invention attenuate its input voltage because it is a voltage divider. However, often it is desirable to have a sharper circuit with at least unity gain. Such gain may be achieved by amplifying the output signal from the divider network as shown in Fig. 3A and 3B, or by scaling the input signal to the divider network as shown in Fig. 3C and 3D.

The shaping networks according to the present invention and shown in Fig. 3A to 3D to introduce a controlled amount of second order non-linearity to the voltage divider transfer function whereby the second order term opposes the first order linear term. It should be noted that, if desirable, the sign of the second order term may be changed by interchanging the source and drain connections in the configuration shown or by using a p-channel FET.

Referring again to Fig. 3A-3D, if g(v) is the transfer function of the resistive dividers 30 and 33, and A is

EP 0 160 149 B1

the gain of the amplifiers 35 and 36, then

$$A = \frac{R_{ON} + \alpha R}{R_{ON}}$$

for amplifier 35A and 36A, where

$$\alpha = 1 - \frac{V_{GS}}{V_P}$$

and

$$A = \frac{\alpha R + R_{ON}}{R}$$

for amplifier 35B and 36B
where $g(v) = \mu (V + \beta v^2)$
and generally

$A = \frac{1}{\mu} (V_{GS} = 0)$

There are several constraints on the shaping networks of the present invention. The first is

$$|V_{IN}| \ll \frac{|V_P| (R_{ON} + R)^2}{R_{ON} R}$$

This constraint is necessary to satisfy the assumption underlying the series expansions of Appendix A.

$V_{DS} < |V_P|$

This is a necessary condition for calculation of the drain current of the FET in the unsaturated region. If $V_{DS} > |V_P|$, the FET will saturate.

$V_{DS} > -0.5v$

This implies that $V_{DS\ PK} < 0.5v$

If $V_{DS} > -0.5v$

the gate-drain junction will be forward biased and gate current will flow. The resultant current flow will

5

dramatically alter the FET transfer function. Thus, this constraint is the most important to observe since $|V_P|$ is usually greater than 0.5v.

<u>APPENDIX A</u>

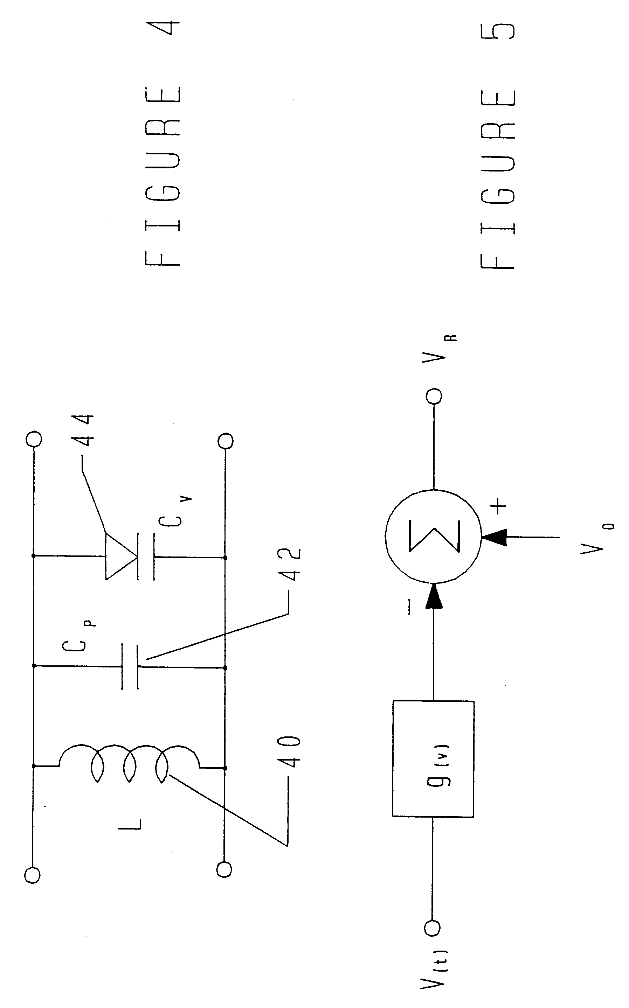

Referring to Fig. 4, the capacitance, $C_v$, of varactor 44 is given by:

$$C_v = C_c + \frac{C_o}{(1 + \frac{V_R}{\phi})^\sigma}$$

where:     $C_c$ = Case capacitance

$C_o$ = Junction capacitance at $V_R$ = 0v

$\phi$ = Junction contact potential

$\sigma$ = Diode power Uw

$V_R$ = Diode reverse bias

Typically $\phi \approx 0.6$v and $\sigma = 0.44$.

For simplicity, lump $C_c$ in with $C_p$ so that $C_p$ represents the total tank capacitance less the contribution of the varactor junction. The tank resonant frequency is:

$$f = \frac{1}{2\pi \sqrt{L(C_p + \frac{C_o}{(1 + \frac{V_o}{\phi})^\sigma}}}$$

$$\frac{df}{dV_R} = \frac{1}{2\pi \sqrt{L} \left(C_p + \frac{C_o}{(1 + \frac{V_R}{\phi})^\sigma}\right)^{3/2}} \cdot (-1/2) \frac{C_o}{(1 + \frac{V_R}{\phi})^{[\sigma + 1]}} \cdot -\frac{\sigma}{\phi}$$

Define $f_o$ as the normal osc. frequency, obtained when $V_R = V_o$

$$f_o \triangleq \frac{1}{2\pi \sqrt{L \left(C_p + \left[\frac{C_o}{(1 + \frac{V_o}{\phi})^\sigma}\right]\right)}}$$

$$\frac{df}{dV_R} = \frac{1}{2\pi \sqrt{L\left(C_p + \dfrac{C_o}{[1 + \frac{V_R}{\phi}]^\sigma}\right)}} \cdot \frac{\sigma\, C_o}{2\phi\left(C_p + \dfrac{C_o}{[1 + \frac{V_R}{\phi}]^\sigma}\right)} \cdot \frac{1}{(1 + \frac{V_R}{\phi})^{\sigma+1}}$$

$$\frac{df}{dV_R}\bigg|_{(V_R = V_o)} = f_o \cdot \frac{\sigma\, C_o}{2\phi\,(1 + \frac{V_R}{\phi})\,(C_p\,[1 + \frac{V_R}{\phi}]^\sigma + C_o)}$$

Example:

$L$ = 50 mH $\qquad\qquad$ $C_p$ = 9,77 pf

$C_4$ = 47 pf $\qquad\qquad$ $V_o$ = 40v

$C_4 = \dfrac{C_o}{(1 + \frac{4}{\phi})^\sigma}$ $\qquad\qquad \therefore\ C_o = C_4\,(1 + \frac{4}{\phi})^\sigma$

Let $\phi = 0.6$ and $\sigma = 0.44$ : $\quad C_o = 47\text{ pf}\left(1 + \frac{4}{0.6}\right)^{0.44}$

$C_o$ = 115,17 pf

$$f_o = \frac{1}{2\pi \sqrt{50\text{ mH}\left(9.77\text{ pf} + \dfrac{115,17\text{ pf}}{[1 + \frac{40}{0.6}]^{0.44}}\right)}} = 135.00\text{ mHz}$$

$$\frac{df}{dV_R}\bigg|_{(V_R = 40v)} = \frac{135 \times 10^6 \times 0.44 \times 115.17\text{ pf}}{2(0.6)\,(1 + \frac{40}{0.6})\,(9.77\text{ pf}\,[1 + \frac{40}{0.6}]^{0.44} + 115,17\text{ pf})}$$

$$= 135 \times 10^6 \times 3.5143 \times 10^{-3}$$

$$= 474\text{kHz/v}$$

Referring now to Fig. 5, assume modulating signal, $v(t)$, is passed through shaping network, $g(v)$, and summed with tune voltage, $V_o$. Then:

$$f = \frac{1}{2\pi \sqrt{L \left( C_p + \dfrac{C_o}{\left[ 1 + \dfrac{V_o - g(v)}{\phi} \right]^{\sigma}} \right)}}$$

Let

$$x = C_p + \frac{C_o}{\left[ 1 + \dfrac{V_o - g(v)}{\phi} \right]^{\sigma}}$$

$\therefore$

$$f = \frac{1}{2\pi \sqrt{L\,x}}$$

$$\frac{df}{dv} = \frac{1}{2\pi \sqrt{L}} \cdot x^{-3/2} \left( -\frac{1}{2} \right) \frac{dx}{dg} \cdot \frac{dg}{dv}$$

The goal is to remove voltage dependance in $\dfrac{df}{dv}$. Note $v \triangleq v(t)$.

Thus, let $\dfrac{df}{dv} = -K_v$

$$\frac{-x^{-3/2}}{4\pi L} \cdot \frac{dx}{dv} = -K_v$$

$$\int \frac{-x^{-3/2}}{4\pi L}\, dx = -\int K_v\, dv$$

$$\frac{1}{4\pi L} \cdot \frac{x^{-1/2}}{-1/2} = -K_v V + \beta \qquad \text{where } \beta = \text{constant of integration}$$

$$\text{units} = Hz$$

EP 0 160 149 B1

$$\sqrt{x} = \frac{1}{2\pi \sqrt{L} \, (-K_v V + \beta)}$$

$$x = \frac{1}{4\pi^2 L \, (-K_v V + \beta)^2}$$

But $\quad x = C_p + \dfrac{C_o}{\left[1 + \dfrac{V_o - g(v)}{\phi}\right]^\sigma}$

$$\therefore \quad \frac{1}{4\pi^2 L \, (-K_v V + \beta)^2} = C_p + \frac{C_o}{\left[1 + \dfrac{V_o - g(v)}{\phi}\right]^\sigma}$$

$$\frac{C_o}{\left[1 + \dfrac{V_o - g(v)}{\phi}\right]^\sigma} = \frac{1}{4\pi^2 L \, (-K_v V + \beta)^2} - C_p$$

$$\left[1 + \frac{V_o - g(v)}{\phi}\right] = \left\{ \frac{C_o}{\dfrac{1}{4\pi^2 L \, (-K_v V + \beta)^2} - C_p} \right\}^{1/\sigma}$$

$$g(v) = \phi \left\{ \frac{C_o}{\dfrac{1}{4\pi^2 L \, (-K_v V + \beta)^2} - C_p} \right\}^{1/\sigma} - \phi - V_o$$

It is desirable that $g(v) = 0$ when $v(t) = 0$. Applying this constraint:

9

$$0 = -\phi \left[ \frac{C_o}{\frac{1}{4\pi^2 L\beta^2} - C_p} \right]^{1/\sigma} + \phi + V_o$$

$$1 + \frac{V_o}{\phi} = \left[ \frac{C_o}{\frac{1}{4\pi^2 L\beta^2} - C_p} \right]^{1/\sigma}$$

$$\left(1 + \frac{V_o}{\phi}\right)^{\sigma} = \frac{C_o}{\frac{1}{4\pi^2 L\beta^2} - C_p}$$

$$\frac{1}{4\pi^2 L\beta^2} - C_p = \frac{C_o}{(1 + \frac{V_o}{\phi})^{\sigma}}$$

Note that $\dfrac{C_o}{(1 + \frac{V_o}{\phi})^{\sigma}}$ = varactor capacitance at average tune voltage.

Define: $C_{av} = \dfrac{C_o}{(1 + \frac{V_o}{\phi})^{\sigma}}$

$$\frac{1}{4\pi^2 L\beta^2} - C_p = C_{av}$$

$$\frac{1}{4\pi^2 L\beta^2} = C_{av} + C_p$$

$$\beta^2 = \frac{1}{4\pi^2 L (C_{av} + C_p)}$$

$$\beta = \frac{1}{2\pi \sqrt{L (C_{av} + C_p)}} \qquad \therefore \quad \beta = f_o$$

then
$$g(v) = -\phi \left[ \frac{C_o}{\dfrac{1}{4\pi^2 L (-K_v V + f_o)^2} - C_p} \right]^{1/\sigma} + \phi + V_o$$

Note that $K_v V$ represents the peak deviation of the modulated oscillator $\Delta f << f_o$.

$$g(v) = -\phi \left[ \frac{C_o}{\dfrac{1}{4\pi^2 L (-K_v V + f_o)^2} - C_p} \right]^{1/c} + \phi + V_o$$

Isolating the term $\dfrac{1}{(-K_v V + f_o)^2}$, performing a series expansion and

retaining the first three terms of the expansion,

$$\left(1 - \frac{K_v}{f_o} V\right)^{-2} \simeq 1 + 2 \frac{K_v}{f_o} V + 3 \frac{K_v^2}{f_o^2} V^2$$

$$\therefore \quad \frac{1}{(-K_v V + f_o)^2} \simeq \frac{\left(1 + 2 \dfrac{K_v}{f_o} V + 3 \dfrac{K_v^2}{f_o^2} V^2\right)}{f_o^2}$$

11

EP 0 160 149 B1

Substituting into g(v):

$$g(v) = -\phi \left[ \cfrac{C_o}{\cfrac{(1 + 2\,\dfrac{K_v}{f_o}\,V + 3\,\dfrac{K_v^2}{f_o^2}\,V^2)}{4\pi^2 L f_o^2} - C_p} \right]^{1/\sigma} + \phi + V_o$$

Previously, $\quad \dfrac{1}{4\pi^2 L f_o^2} = C_p + C_{av}$ ,

Thus:

$$g(v) = -\phi \left[ \cfrac{C_o}{(C_{av} + C_p)\left[1 + 2\,\dfrac{K_v}{f_o}\,V + 3\,\dfrac{K_v^2}{f_o^2}\,V^2\right] - C_p} \right]^{1/\sigma} + \phi + V_o$$

$$= -\phi \left[ \cfrac{C_o}{C_{av} + (C_{av} + C_p)\left[2\,\dfrac{K_v}{f_o}\,V + 3\,\dfrac{K_v^2}{f_o^2}\,V^2\right]} \right]^{1/\sigma} + \phi + V_o$$

$$= -\phi \left(\dfrac{C_o}{C_{av}}\right)^{1/\sigma} \left[ \cfrac{1}{1 + (1 + \dfrac{C_p}{C_{av}})(2\,\dfrac{K_v V}{f_o} + 3\,\dfrac{K_v^2}{f_o^2}\,V^2)} \right]^{1/\sigma} + \phi + V_o$$

The term in brackets is of the form:

$$( 1 + av + bv^2 )^{-1/\sigma}$$

12

where:
$$a = 2 \frac{K_v}{f_o} (1 + \frac{C_p}{C_{av}})$$

$$b = 3 \frac{K_v^2}{f_o^2} (1 + \frac{C_p}{C_{av}})$$

Let $f(v) = (1 + av + bv^2)^{-1/\sigma}$

$$f(o) = 1$$

$$f'(v) = -\frac{1}{\sigma} (1 + av + bv^2)^{-1/\sigma - 1} \cdot (a + 2bv)$$

$$f'(o) = -\frac{a}{\sigma}$$

$$f''(v) = \frac{1}{\sigma} \frac{(1 + \sigma)}{\sigma} (1 + av + bv^2)^{-1/\sigma - 2} (a + 2bv)^2$$

$$-\frac{1}{\sigma} (1 + av + bv^2)^{-\frac{(1 + \sigma)}{\sigma}} \quad (2b)$$

$$f''(o) = \frac{1 + \sigma}{\sigma^2} a^2 - \frac{2b}{\sigma}$$

$$f(v) = f(o) + \frac{f'(o)}{1!} v + \frac{f''(o)}{2!} v^2 + \frac{f'''(o)}{3!} v^3 + \ldots$$

$$f(v) = 1 - \frac{a}{\sigma} v + (\frac{1 + \sigma}{\sigma^2} a^2 - \frac{2b}{\sigma}) \frac{v^2}{2} + \ldots$$

I shall keep only the first three terms since I am looking for a quadratic approximation.

$$g(v) = -\phi \left(\frac{C_o}{C_{av}}\right)^{1/\sigma} \left[1 - \frac{2K_v}{\sigma f_o} \left(1 + \frac{C_p}{C_{av}}\right) \cdot v + \left\{\frac{1 + \sigma}{\sigma^2} \left(\frac{2K_v}{f_o} \left[1 + \frac{C_p}{C_{av}}\right]\right)^2 - \frac{6K_v^2}{\sigma f_o^2}\right.\right.$$

$$\left.\left.\left[1 + \frac{C_p}{C_{av}}\right]\right\} \frac{v^2}{2}\right] + \sigma + V_o$$

Previously, it was shown that:

$$\phi \left( \frac{C_o}{C_{av}} \right)^{1/\sigma} = (\phi + V_o)$$

$$\therefore g(v) = - (V_o + \phi) \left[ \frac{-2K_v}{\sigma f_o} \left( 1 + \frac{C_p}{C_{av}} \right) v + \left\{ \frac{1 + \sigma}{\sigma^2} \frac{4K_v^2}{f_o^2} \left( 1 + \frac{C_p}{C_{av}} \right)^2 - \frac{6K_v^2}{\sigma f_o^2} \right. \right.$$

$$\left. \left. \left( 1 + \frac{C_p}{C_{av}} \right) \right\} \frac{v^2}{2} \right]$$

Previously, it was shown that:

$$\frac{2 K_v}{\sigma f_o} \left( 1 + \frac{C_p}{C_{av}} \right) (V_o + \phi) = 1$$

Using this result:

$$g(v) = v - \frac{4K_v^2}{\sigma^2 f_o^2} \left( 1 + \frac{C_p}{C_{av}} \right)^2 (V_o + \phi)^2 \left[ \frac{1 + \sigma}{(V_o + \phi)} - \frac{6\sigma}{4 \left( 1 + \frac{C_p}{C_{av}} \right)(V_o + \phi)} \right] \frac{v^2}{2}$$

$$= v - \frac{1}{V_o + \phi} \left( \frac{1 + \sigma}{2} - \frac{3\sigma}{4 \left( 1 + \frac{C_p}{C_{av}} \right)} \right) v^2$$

$$g(v) = v - \left[ \frac{1 + \sigma}{2} - \frac{3\sigma}{4 \left( 1 + \frac{C_p}{C_{av}} \right)} \right] \frac{v^2}{\phi + V_o} \qquad \text{(EQUATION A)}$$

This is the required second order shaping.

APPENDIX  B

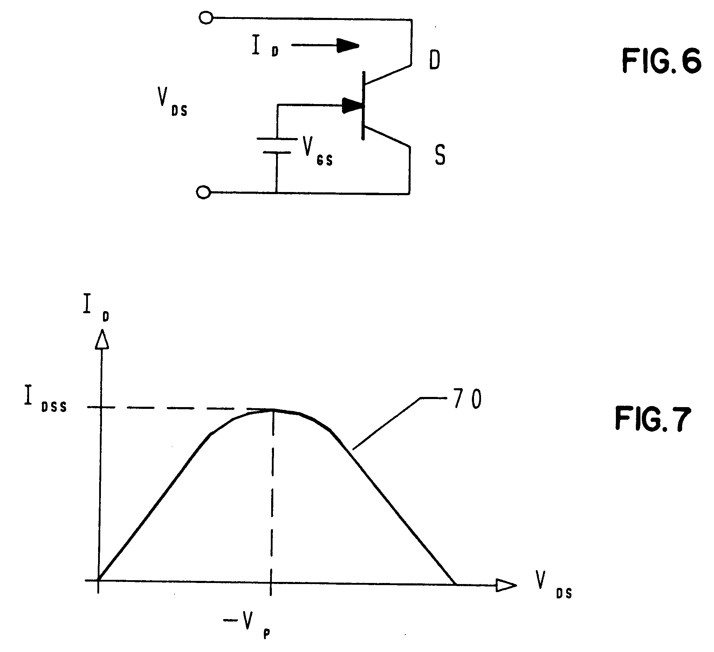

Referring to Fig. 6, for a symmetrical junction FET, the most positive junction controls the current flow, $I_D$, in an N-channel device. A quadratic approximation of unsaturated drain current can be derived by assuming the substantially parabolic characteristic curve 70 as shown in Fig. 7. Thus,

$$I_D = \frac{2I_{DSS}}{v_p^2} \; v_{DS} \left( v_{GS} - v_p - \frac{v_{DS}}{2} \right)$$

Since the same relation describes the behavior of $I_D$ in both quadrants 1 and 3,

$$r_{DS\ ON} \; \triangleq \; \left. \frac{dv_{DS}}{dI_D} \right|_{v_{DS} = 0}$$

$$\frac{dv_{DS}}{dI_D} = \frac{1}{dI_D/dv_{DS}}$$

$$\frac{dI_D}{dv_{DS}} = \frac{2I_{DSS}}{v_p^2} \left( v_{GS} - v_p - \frac{v_{DS}}{2} \right) + \frac{2I_{DSS}}{v_p^2} \; v_{DS} \left( \frac{-1}{2} \right)$$

$$\left. \frac{dI_D}{dv_{DS}} \right|_{v_{DS} = 0} = \frac{2I_{DSS}}{v_p^2} \left( v_{GS} - v_p \right)$$

$$r_{DS\ ON} = \frac{v_p^2}{2I_{DSS}(v_{GS} - v_p)}$$

$$R_{ON} = \left. r_{DS\ ON} \right|_{v_{GS} = 0} = \frac{-v_p}{2I_{DSS}}$$

15

$$I_D = \frac{-V_{DS}}{R_{ON}V_p} \left(V_{GS} - V_p - \frac{V_{DS}}{2}\right)$$

$$\text{Let} \quad V \triangleq V_{GS} - V_p$$

$$I_D = \frac{-V_{DS}}{R_{ON}V_p} \left(V - \frac{V_{DS}}{2}\right)$$

For resistive voltage dividers 30, (Fig. 3A, 3C)

$$V_{IN} = -I_D R - V_{DS}$$

$$V_{IN} = (-R) \frac{(-V_{DS}}{R_{ON}V_p} \left[V - \frac{V_{DS}}{2}\right]) - V_{DS}$$

$$= \frac{R}{R_{ON}V_p} \left(V_{DS} V - \frac{V_{DS}^2}{2}\right) - V_{DS}$$

$$V_{IN} \frac{R_{ON}V_p}{R} = V_{DS}V - \frac{V_{DS}^2}{2} - V_{DS} \frac{R_{ON}V_p}{R}$$

$$V_{DS}^2 - 2V_{DS}V + 2V_{DS} \frac{R_{ON}V_p}{R} = -2V_{IN} \frac{R_{ON}V_p}{R}$$

$$V_{DS}^2 + V_{DS} \left(\frac{2R_{ON}V_p}{R} - 2V\right) + \frac{2R_{ON}}{R} V_{IN} V_p = 0$$

At this point, note that $V_p \leq V_{GS} \leq 0$. Therefore, $V = V_{GS} - V_p$.

$$0 \leq V \leq -V_p$$

Let $V = -\alpha V_p$ ; where $0 \leq \alpha \leq 1$. Note, $\alpha = 0$ when $V_{GS} = V_p$, and $\alpha = 1$ when $V_{GS} = 0v$.

$$V_{DS}^2 + V_{DS} \left(\frac{2R_{ON}}{R} V_p + 2\alpha V_p\right) + \frac{2R_{ON}}{R} V_{IN} V_p = 0$$

$$V_{DS} = \frac{- \left(\frac{2R_{ON}}{R} V_p + 2\alpha V_p\right) \pm \sqrt{\left(\frac{2R_{ON}}{R} V_p + 2\alpha V_p\right)^2 - 8 \frac{R_{ON}}{R} V_{IN} V_p}}{2}$$

If $V_{IN} = 0$, $V_{DS}$ must $= 0$. $V_p < 0$ and $\left(\frac{R_{ON}}{R} + \alpha\right) > 0$.

Therefore, $-2V_p \left(\frac{R_{ON}}{R} + \alpha\right) > 0$. Since the square root will be positive, the negative radical must be taken.

$$V_{DS} = \frac{- \left(\frac{2R_{ON}}{R} V_p + 2\alpha V_p\right) - \sqrt{\left[2V_p \left(\frac{R_{ON}}{R} + \alpha\right)\right]^2 - \frac{8R_{ON} V_{IN}}{R} V_p}}{2}$$

$$= - V_p \left(\alpha + \frac{R_{ON}}{R}\right) - \sqrt{\left[V_p \left(\frac{R_{ON}}{R} + \alpha\right)\right]^2 - \frac{2R_{ON}}{R} V_{IN} V_p}$$

$$= - V_p \left(\frac{\alpha R + R_{ON}}{R}\right) - \sqrt{\left[V_p \left(\frac{R_{ON} + \alpha R}{R}\right)\right]^2 - 2 \frac{R_{ON} V_{IN}}{R} V_p}$$

$$= - V_p \frac{(\alpha R + R_{ON})}{R} \left[ + 1 + \sqrt{1 - \frac{2 R_{ON} V_{IN} V_p R^2}{R V_p^2 (R_{ON} + \alpha R)^2}} \; \right]$$

$$= - V_p \frac{(\alpha R + R_{ON})}{R} \left[ + 1 - \sqrt{1 - \frac{2 R_{ON} R V_{IN}}{V_p (R_{ON} + \alpha R)^2}} \; \right] \qquad \text{"K"}$$

Assume $R \gg R_{ON}$ : Then the radical becomes:

$$\sqrt{1 - \frac{2 \frac{R_{ON}}{R}}{\left(\alpha + \frac{R_{ON}}{R}\right)^2} \; \frac{V_{IN}}{V_p}}$$

Perform a series expansion and retain the first three terms.

$$v_{DS} = - V_p \frac{(\alpha R + R_{ON})}{R} \left[ + 1 - \left( - \frac{2 R_{ON} R \cdot \frac{1}{2}}{V_p (R_{ON} + \alpha R)^2} \cdot V_{IN} - \frac{4 R_{ON}^2 R^2 \cdot \frac{1}{8}}{V_p^2 (R_{ON} + \alpha R)^4} \cdot v_{IN}^2 \right) \right]$$

$$= - V_p \frac{(\alpha R + R_{ON})}{R} \left[ + \frac{R_{ON} R}{V_p (R_{ON} + \alpha R)^2} \cdot V_{IN} + \frac{R_{ON}^2 R^2}{2 V_p^2 (R_{ON} + \alpha R)^4} \cdot v_{IN}^2 \right]$$

$$= - \frac{R_{ON}}{R_{ON} + \alpha R} \cdot v_{IN} - \frac{R_{ON}^2 R}{2 V_p (R_{ON} + \alpha R)^3} \cdot v_{IN}^2$$

18

$$v_{OUT} = -v_{DS}$$

So:

$$v_{OUT} \simeq \frac{R_{ON}}{R_{ON} + \alpha R} \cdot v_{IN} + \frac{R_{ON}^2 R}{2V_p (R_{ON} + \alpha R)^3} \cdot v_{IN}^2$$

If $\alpha = 1 \Rightarrow V_{GS} = 0$

$$v_{OUT} \simeq \frac{R_{ON}}{R_{ON} + R} \cdot v_{IN} + \frac{R_{ON}^2 R}{2V_p (R_{ON} + R)^3} \cdot v_{IN}^2$$

Note that $V_p < 0$

$$V_{OUT} = \frac{R_{ON}}{R_{ON} + R} \cdot V_{IN} - \left[ \frac{R^2_{ON} R}{2 |V_P| (R_{ON} + R)^3} \right] V^2_{IN} \quad (EQUATION\ B)$$

For this approximation to be valid,

$$\left| v_{IN} \right| << \left| V_p \right| \frac{2(R_{ON} + \alpha R)^2}{2R_{ON}R} \qquad "M"$$

Since a resistive-voltage divider attenuates the input voltage, all input voltages must be pre-amplified by an amount approximately equal to $\frac{R_{ON} + R}{R_{ON}}$ to restore the amplitude of the output signal if a post shaping network amplifier is not used.

APPENDIX C

For resistive voltage divider 33, (Figures 3B, 3D)

$$v_{IN} = I_D R + v_{DS} \qquad\qquad v_{OUT} = v_{IN} - v_{DS}$$

As before, $\quad I_D = \dfrac{-v_{DS}}{R_{ON} V_p} \left( V - \dfrac{v_{DS}}{2} \right)$

$v \triangleq v_{GS} - V_p \qquad$ As previously stated, let $\quad V = -\alpha V_p$

$$v_{IN} = \frac{R v_{DS}}{R_{ON} V_p} \left( \alpha V_p + \frac{v_{DS}}{2} \right) + v_{DS}$$

$$= \frac{R}{R_{ON}} v_{DS} \alpha + \frac{R v_{DS}^2}{2 R_{ON} V_p} + v_{DS}$$

$$\frac{2 R_{ON}}{R} V_p v_{IN} = 2 V_p v_{DS} \alpha + v_{DS}^2 + \frac{2 R_{ON}}{R} V_p v_{DS}$$

$$v_{DS}^2 + v_{DS} \left( 2 V_p \alpha + 2 \frac{R_{ON}}{R} V_p \right) - 2 \frac{R_{ON} V_p}{R} v_{IN} = 0$$

20

$$v_{DS} = \frac{-2v_p (\alpha + \frac{R_{ON}}{R}) \pm \sqrt{(2v_p [\alpha + \frac{R_{ON}}{R}])^2 + \frac{8R_{ON}v_p v_{IN}}{R}}}{2}$$

$$= -v_p (\frac{\alpha R + R_{ON}}{R}) \pm \sqrt{(v_p [\frac{\alpha R + R_{ON}}{R}])^2 + \frac{2R_{ON}v_p v_{IN}}{R}}$$

The negative radical must be used so that $v_{DS} = 0v$ when $v_{IN} = 0v$.

$$v_{DS} = -v_p (\frac{\alpha R + R_{ON}}{R}) \left[ 1 - \sqrt{1 + \frac{2R_{ON}v_p v_{IN}}{R} \cdot \frac{R^2}{(\alpha R + R_{ON})^2 v_p^2}} \right]$$

$$= -v_p (\frac{\alpha R + R_{ON}}{R}) \left[ 1 - \sqrt{1 + \frac{2R_{ON}R v_{IN}}{(\alpha R + R_{ON})^2 v_p}} \right]$$

The radical has the same form as the radical in equation "K" for resistive voltage divider 30. Therefore, isolating and applying condition "M",

$$f(v) = 1 + \frac{R_{ON}R}{(\alpha R + R_{ON})^2} \cdot \frac{v_{IN}}{v_p} - \frac{R_{ON}^2 R^2 v^2}{2(\alpha R + R_{ON})^4 v_p^2}$$

$$v_{DS} = -v_p (\frac{\alpha R + R_{ON}}{R}) \left[ 1 - \left(1 + \frac{R_{ON}R}{(\alpha R + R_{ON})^2} \cdot \frac{v_{IN}}{v_p} - \frac{R_{ON}^2 R^2 v_{IN}^2}{2(\alpha R + R_{ON})^4 v_p^2} \right) \right]$$

$$= -v_p (\frac{\alpha R + R_{ON}}{R}) \left[ \frac{-R_{ON}R}{(\alpha R + R_{ON})^2} \cdot \frac{v_{IN}}{v_p} + \frac{R_{ON}^2 R^2 v_{IN}^2}{2(\alpha R + R_{ON})^4 v_p^2} \right]$$

$$= \frac{R_{ON} v_{IN}}{(\alpha R + R_{ON})} - \frac{R_{ON}^2 R\ v_{IN}^2}{2(\alpha R + R_{ON})^3 v_p}$$

Remember that $v_{OUT} = v_{IN} - v_{DS}$

$$\Rightarrow v_{OUT} = v_{IN} - \frac{R_{ON}\ v_{IN}}{\alpha R + R_{ON}} + \frac{R_{ON}^2 R\ v_{IN}^2}{2(\alpha R + R_{ON})^3 v_p}$$

$$= \frac{\alpha R}{\alpha R + R_{ON}} \cdot v_{IN} + \frac{R_{ON}^2 R\ v_{IN}^2}{2(\alpha R + R_{ON})^3 v_p}$$

But $V_p < 0$ ;

$$v_{OUT} = \frac{\alpha R}{\alpha R + R_{ON}} \cdot v_{IN} - \frac{R_{ON}^2 R\ v_{IN}^2}{2|V_p|(\alpha R + R_{ON})^3}$$

$$= \frac{\alpha R}{\alpha R + R_{ON}} \cdot \left[ v_{IN} - \frac{R_{ON}^2\ v_{IN}^2}{2\alpha|V_p|(\alpha R + R_{ON})^2} \right]$$

If $\alpha = 1$ (i.e. $V_{GS} = 0$)

$$\Rightarrow$$

$$v_{OUT} = \frac{R}{R + R_{ON}} \cdot \left[ v_{IN} - \frac{R_{ON}^2}{2|V_p|(R + R_{ON})^2}\ v_{IN}^2 \right]$$

## Claims

1. A network for reducing distortion in the modulation of the output signal of a voltage controlled oscillator, said network comprising a voltage divider (30, 33) coupled to the voltage controlled oscillator for shaping its modulating signal, the network having a characteristic transfer function,
characterized in that
said voltage divider includes as one of its resistive elements a field effect transistor (32) biased for unsaturated non-linear operation for providing a controllable non-linear resistance, said field effect transistor (32) being coupled in parallel to the input path of said network (30) and introducing a controlled amount of second order non-linearity to said characteristic transfer function which is given by the relation:

$$V_{OUT} = \frac{R_{ON}}{R_{ON} + R} \cdot V_{IN} - \left[ \frac{R^2_{ON} R}{2 |V_P| (R_{ON} + R)^3} \right] V^2_{IN}$$

where $R_{ON}$ is the resistance of the drain-to-sink channel of the field effect transistor evaluated when the gate-to-sink voltage is zero, R is the resistance of a resistor element (31) of the voltage divider, said resistor element being serially coupled to the input path of said network (30), $V_P$ is the pinch-off voltage for the field effect transistor (32) and $V_{IN}$ and $V_{OUT}$ are the input voltage and output voltage of said network, respectively.

2. A network for reducing distortion in the modulation of the output signal of a voltage controlled oscillator, said network comprising a voltage divider (30, 33) coupled to the voltage controlled oscillator for shaping its modulating signal, the network having a characteristic transfer function
characterized in that
said voltage divider includes as one of its resistive elements a field effect transistor (32) biased for unsaturated non-linear operation for providing a controllable non-linear resistance, said field effect transistor (32) being coupled in series to the input path of said network (33) and introducing a controlled amount of second order non-linearity to said characteristic transfer function which is given by the relation

$$V_{OUT} = \frac{R}{R + R_{ON}} \cdot \left[ V_{IN} - \frac{R^2_{ON}}{2 |V_P| (R + R_{ON})^2} V^2_{IN} \right],$$

where $R_{ON}$ is the resistance of the drain-to-sink channel of the field effect transistor evaluated when the gate-to-sink voltage is zero, R is the resistance of a resistor (31) of the voltage divider, said resistor being coupled in parallel to the input path of said network (33), $V_P$ is the pinch-off voltage for the field effect transistor (32) and $V_{IN}$ and $V_{OUT}$ are the input voltage and output voltage of the network (33), respectively.

3. The network according to claim 1 or 2,
characterized by a voltage amplifier (35 A-35B) which has a predetermined gain and is coupled between said voltage divider (30; 33) and said voltage controlled oscillator for amplifying said shaped modulating signal.

4. The network according to one or more of the preceding claims,
characterized by a summing circuit coupled between said voltage divider and said voltage controlled oscillator for summing said L shaped modulating signal with an oscillator tuning voltage ($V_O$).

**Revendications**

1. Un circuit pour réduire une distorsion dans la modulation du signal de sortie d'un oscillateur commandé en tension, ledit circuit comprenant un diviseur de tension (30, 33) relié à l'oscillateur commandé en tension pour mettre en forme son signal de modulation, le réseau ayant une fonction de transfert caractéristique, caractérisé en ce que ledit diviseur de tension comprend, comme un de ses éléments résistifs, un transistor à effet de champ (32) polarisé pour un fonctionnement non linéaire insaturé en vue de créer une résistance non linéaire contrôlable, ledit transistor à effet de champ (32) étant couplé en parallèle à la voie d'entrée dudit circuit (30) et introduisant une quantité contrôlée de linéarité de second ordre dans ladite fonction de transfert caractéristique, qui est définie par la relation :

$$V_{OUT} = \frac{R_{ON}}{R_{ON} + R} \cdot V_{IN} - \left[ \frac{R^2_{ON} \quad R}{2 \, |V_P| \, (R_{ON} + R)^3} \right] V^2_{IN}$$

où $R_{ON}$ est la résistance du canal drain-vers-puits du transistor à effet de champ, évaluée lorsque la tension grille-vers-puits est nulle, R désigne la résistance d'un élément résistif (31) du diviseur de tension, ledit élément résistif étant couplé en série avec la voie d'entrée dudit circuit (30), $V_P$ désigne la tension de pincement du transistor à effet de champ (32) et $V_{IN}$ et $V_{OUT}$ désignent respectivement la tension d 'entrée et la tension de sortie dudit circuit.

2. Un circuit pour réduire une distorsion dans la modulation du signal de sortie d'un oscillateur commandé en tension, ledit circuit comprenant un diviseur de tension (30, 33) relié à l'oscillateur commandé en tension pour mettre en forme son signal de modulation, le réseau ayant une fonction de transfert caractéristique, caractérisé en ce que ledit diviseur de tension comprend, comme un de ses éléments résistifs, un transistor à effet de champ (32) polarisé pour un fonctionnement non linéaire insaturé en vue de créer une résistance non linéaire contrôlable, ledit transistor à effet de champ (32) étant couplé en parallèle à la voie d'entrée dudit circuit (33 et introduisant une quantité contrôlée de linéarité de second ordre dans ladite fonction de transfert caractéristique, qui est définie par la relation :

$$V_{OUT} = \frac{R}{R + R_{ON}} \cdot \left[ V_{IN} - \frac{R^2_{ON}}{2 \, |V_P| \, (R + R_{ON})^2} V^2_{IN} \right]$$

où $R_{ON}$ est la résistance du canal drain-vers-puits du transistor à effet de champ, évaluée lorsque la tension grille-vers-puits est nulle, R désigne la résistance d'un élément résistif (31) du diviseur de tension, ledit élément résistif étant couplé en série avec la voie d'entrée dudit circuit (33), $V_P$ désigne la tension de pincement du transistor à effet de champ (32) et $V_{IN}$ et $V_{OUT}$ désignent respectivement la tension d'entrée et la tension de sortie dudit circuit (33).

3. Le circuit selon la revendication 1 ou 2, caractérisé par un amplificateur de tension (35A - 35B) qui a un gain prédéterminé et qui est couplé entre ledit diviseur de tension (30 ; 33) et ledit oscillateur commandé en tension pour amplifier ledit signal de modulation mis en forme.

4. Le circuit selon une ou plusieurs des revendications précédentes, caractérisé par un circuit de sommation couplé entre ledit diviseur de tension et ledit oscillateur commandé en tension pour additionner ledit signal de modulation mis en forme avec une tension ($V_O$) d'accord d'oscillateur.

**Patentansprüche**

1. Netzwerk zur Verringerung von Verzerrungen in der Modulation des Ausgangssignals eines spannungsgesteuerten Oszillators, welches einen mit dem spannungsgesteuerten Oszillator verbundenen Spannungsteiler (30, 33) zur Formung von dessen Modulationssignal und eine charakteristische Übertragungsfunktion aufweist,

dadurch gekennzeichnet, daß

der Spannungsteiler als eines seiner Widerstandsglieder einen Feldeffekttransistor (32) enthält, der für einen ungesättigten, nichtlinearen Betrieb, um einen steuerbaren, nichtlinearen Widerstand zu erzeugen, vorgespannt, parallel zum Eingangsweg des Netzwerks (30) eingeschaltet ist und der charakteristischen Übertragungsfunktion eine Nichtlinearität zweiter Ordnung in gesteuerter Größe hinzufügt, wobei diese Übertragungsfunktion durch folgende Beziehung gegeben ist:

$$V_{out} = \frac{R_{on}}{R_{on} + R} \cdot V_{IN} - \left[ \frac{R^2{}_{on} \ R}{2 \ |V_p| (R_{on} + R)^3} \right] V^2{}_{IN}$$

worin $R_{on}$ der Widerstand des Drain-Sink-Kanals des Feldeffekttransistors bei einer Gate-Sink-Spannung = 0, R der Widerstand eines Widerstandelements (31) des Spannungsteilers, welches seriell im Eingangsweg des Netzwerks (30) eingeschaltet ist, $V_p$ die Pinch-Off-Spannung des Feldeffekttransistors (32) und $V_{in}$ und $V_{out}$ jeweils die Eingangsspannung und Ausgangsspannung des Netzwerks sind.

2. Netzwerk zur Verringerung von Verzerrungen in der Modulation des Ausgangssignals eines spannungsgesteuerten Oszillators, welches einen mit dem spannungsgesteuerten Oszillator verbundenen Spannungsteiler (30, 33) zur Formung von dessen Modulationssignal und eine charakteristische Übertragungsfunktion aufweist,

dadurch gekennzeichnet, daß

der Spannungsteiler als eines seiner Widerstandsglieder einen Feldeffekttransistor (32) enthält, der für einen ungesättigten, nichtlinearen Betrieb zur Erzeugung eines steuerbaren, nichtlinearen Widerstandes vorgespannt, in Reihe zum Eingangsweg des Netzwerks (33) eingeschaltet ist und der charakteristischen Übertragungsfunktion eine Nichtlinearität zweiter Ordnung in gesteuerter Größe hinzufügt, wobei diese Übertragungsfunktion durch folgende Beziehung gegeben ist:

$$V_{out} = \frac{R}{R + R_{on}} \cdot \left[ V_{IN} - \frac{R^2{}_{on}}{2 \ |V_p| (R + R_{on})^2} V^2{}_{IN} \right]$$

worin $R_{on}$ der Widerstand des Drain-Sink-Kanals des Feldeffekttransistors bei der Gate-Sink-Spannung = 0, R der Widerstandswert eines Widerstandsglieds (31) des Spannungsteilers, welches parallel zum Eingangsweg des Netzwerks (33) liegt, $V_p$ die Pinch-Off-Spannung des Feldeffekttransistors (32) und $V_{in}$ und $V_{out}$ jeweils die Eingangsspannung und Ausgangsspannung des Netzwerks (33) sind.

3. Netzwerk nach Anspruch 1 oder 2,

gekennzeichnet durch

einen Spannungsverstärker (35 A-35 B) mit einem vorgegebenen Verstärkungsgrad, der zwischen den Spannungsteiler (30; 33) und den spannungsgesteuerten Oszillator zur Verstärkung des geformten Modulationssignals eingeschaltet ist.

4. Netzwerk nach einem oder mehreren der vorangehenden Ansprüche,

gekennzeichnet durch

eine zwischen den Spannungsteiler und den spannungsgesteuerten Oszillator eingeschaltete Summierschaltung zur Summation des geformten Modulationssignals mit einer Oszillatorabstimmspannung ($V_O$).

25

FIG. 1

FIG. 2

FIGURE 3A

FIGURE 3B

EP 0 160 149 B1

FIGURE 3C

FIGURE 3D

EP 0 160 149 B1

FIGURE 4

FIGURE 5

EP 0 160 149 B1

FIG.6

FIG.7

$V_{DS}$

$I_D$

D

S

$V_{GS}$

$I_D$

$I_{DSS}$

70

$-V_P$

$V_{DS}$